# EUROPÄISCHE PATENTSCHRIFT

(11) **EP 1 304 726 B1**
(45) Veröffentlichungstag und Bekanntmachung des Hinweises auf die Patenterteilung: **18.07.2007**
(21) Anmeldenummer: 02023396.1
(22) Anmeldetag: 18.10.2002
(51) Int. Cl.: H01L 21/00, H01L 21/68, B23Q 3/15

(54) **Anordnung und Verfahren zur Aufnahme und zum Bearbeiten eines dünnen Wafers**
Device and method for receiving and for processing a thin wafer
Dispositif et méthode pour recevoir et pour traiter une plaquette semiconductrice mince

(30) Priorität: 18.10.2001 DE 10151441
(43) Veröffentlichungstag der Anmeldung: 23.04.2003
(73) Patentinhaber: Infineon Technologies AG, 81669 München (DE)
(72) Erfinder: Schmidt, Thomas, 9500 Villach (AT)
(74) Vertreter: Bickel, Michael

(56) Entgegenhaltungen:
- US-A- 5 310 453
- US-A- 5 382 311
- US-A- 5 557 215
- US-A- 5 671 119
- PATENT ABSTRACTS OF JAPAN Bd. 1995, Nr. 06, 31. Juli 1995 (1995-07-31) -& JP 07 074234 A (TOKYO ELECTRON LTD; others: 01), 17. März 1995 (1995-03-17)

## Beschreibung

Die Erfindung betrifft eine Anordnung und ein Verfahren zur Aufnahme, zum Bearbeiten und/oder Testen eines dünnen Wafers.

In der Halbleitertechnologie geht die Tendenz hin zu immer größeren Waferdurchmessern, um dadurch eine größere Anzahl von Halbleiterchips auf ein- und demselben Wafer zu produzieren, wodurch die Kosten für einen einzelnen Halbleiterchip reduziert werden. Zum anderen geht insbesondere bei Leistungshalbleiterbauelementen, wie Leistungs-MOSFETs, JFETs, IGBTs und Thyristoren, die Tendenz hin zu einer Reduzierung der Waferdicke, um dadurch den Einschaltwiderstand zu reduzieren und damit einhergehend die Durchlass- und Schaltverluste des Halbleiterbauelementes zu optimieren. Dünne Wafer sind allerdings bezüglich deren Handhabung sehr empfindlich und können bei der Prozessierung in herkömmlichen Fertigungsanlagen sehr leicht brechen, was insbesondere die Ausbeute signifikant reduziert. Wafer mit immer größeren Durchmessern und geringerer Dicke fordern daher zwangsläufig immer höhere Anforderungen an die zur Prozessierung der Wafer erforderlichen Fertigungsanlagen - beispielsweise Implantationsanlagen, Sputteranlagen, Lithografieanlagen, etc.

Darüber hinaus müssen die Halbleiterbauelemente nach deren Prozessierung auf ihre elektrischen Eigenschaften bzw. auf ihre Funktion hin getestet werden. Zu diesem Zwecke wird der Wafer typischerweise auf einen Chuck einer Testanlage positioniert. Um nacheinander die Vielzahl der einzelnen Halbleiterbauelemente definiert testen zu können, ist ein definierter elektrischer Kontakt des Wafers auf dem Chuck erforderlich, so dass die durch die Messanlage auftretenden Messungenauigkeiten minimal sind und somit für jedes HalbleiterbauElement die gleichen Messbedingungen vorliegen. Für einen Messvorgang wird der Wafer also mit seiner großflächig metallisierten Waferrückseite auf den Chuck beispielsweise über ein Vakuum oder durch elektrostatische Anziehung fixiert, um einen großflächigen Kontakt zwischen Waferrückseite und Chuck zu erhalten. Elektrostatische Chucks sind beispielsweise aus den US-Patentschriften US 5,310,453, US 5,557,215 und US 5,671,119 bekannt, wobei in der US 5,671,119 lediglich ein Reinigungsverfahren für elektrostatische Chucks beschrieben wird. Dies setzt jedoch eine möglichst planare Oberfläche des Wafers an dessen Rückseite voraus. Problematisch daran ist jedoch, dass insbesondere bei sehr dünnen Wafern im Bereich von kleiner 200 µm bei gleichzeitig immer größer werdenden Waferdurchmessern eine solche planare Oberfläche nicht mehr gewährleistet werden kann. Dies liegt daran, dass der Wafer nach dem Dünnschleifen bzw. Dünnätzen statt der erforderlichen Steifigkeit eine mehr oder weniger stark gewellte Oberfläche aufweist. Besonders gravierend ist dies bei sehr dünn geätzten Wafern im Bereich von etwa 70 µm und dünner. Hier ist der Wafer so dünn, dass er quasi wie ein dickes Blatt Papier verbiegbar ist. Ein definiertes Testen ist hier nicht mehr oder nur bedingt möglich.

Daraus folgt jedoch, dass eine definierte Rückseitenkontaktierung solcher dünner Wafer sich mit bisher verwendeten Fertigungs- und Testanlagen - vor allem bei einer aus Kostengründen anzustrebenden hohen Ausbeute - nicht mehr bewerkstelligen lässt.

Eine Möglichkeit, einen Bruch des Wafers zu vermeiden und somit die Ausbeute zu erhöhen kann dadurch erreicht werden, dass die Wafer einzeln, d. h. jeweils manuell auf die Chucks der jeweiligen Fertigungsanlagen aufgelegt werden. Dies ist jedoch äußerst zeitintensiv und mit modernen Fertigungstechniken nicht mehr zu vereinbaren, da die theoretisch mögliche Kapazität einer Fertigungslinie dadurch bei weitem nicht ausgenutzt wird. Zum anderen leidet die Wirtschaftlichkeit der so produzierten Halbleiterbauteile, was deren technische Weiterentwicklung massiv bremst. Der vorliegenden Erfindung liegt daher die Aufgabe zugrunde, einen definierten, gleichmäßigen Kontakt zur Oberfläche eines dünnen Wafers herzustellen. Ferner soll ein Waferbruch beim automatischen Handhaben und Testen eines dünnen Wafers weitestgehend vermieden werden.

Erfindungsgemäß wird diese Aufgabe durch eine Anordnung mit den Merkmalen des Patentanspruchs 1 sowie ein Verfahren mit den Merkmalen des Patentanspruchs 16 gelöst.

Der besondere Vorteil der vorliegenden Erfindung besteht darin, dass die typischerweise durch eine großflächige Metallisierung versehene Rückseite eines Wafers definiert auf ein Raster (Array) von Nadeln aufgelegt werden. Die Nadeln sind vorteilhafterweise in eigens dafür vorgesehene Ausnehmungen (z. B. Bohrungen) eines Chucks vorgesehen und ragen aus diesen Ausnehmungen heraus. Die Nadeln werden mit Federkräften beaufschlagt, so dass gewährleistet ist, dass jede Nadel die Rückseite des Wafers kontaktiert wird.

Beim Auflegen des Wafers auf das Nadelraster geben die mit einer Feder gekoppelten Nadeln geringfügig nach. Auf diese Weise wird die Auflegbewegung geringfügig gepuffert, was einen Waferbruch beim Auflegvorgang und beim Handhaben zusätzlich verringert. Statt mittels einer Feder können die Nadeln auch anderweitig gepuffert werden, beispielsweise hydraulisch, pneumatisch, etc.

Bei geeigneter Wahl des Nadelrasters, beispielsweise durch Vorsehen von äquidistanten Abständen benachbarter Nadeln, wird zwar keine großflächige Kontaktierung gewährleistet, wie dies beim Stand der Technik der Fall ist. Jedoch kann sichergestellt werden, dass die Waferrückseite punktuell, jedoch gleichmäßig kontaktiert ist. Diese punktuelle Kontaktierung der Waferrückseite funktioniert dank der gefederten Nadeln auch dann, wenn dessen Oberfläche mehr oder weniger stark gewellt, gebogen oder leicht verdreht (Torsion) ist oder auch wenn der Wafer unterschiedliche Dicken aufweist.

In einer Ausgestaltung weist die Folie eine Vielzahl Löcher auf, durch die die Nadelnspitze mindestens einer Nadel die erste Oberfläche des Wafers kontaktiert. Besonders vorteilhaft ist es, wenn die Löcher und die Ausnehmungen das gleich Raster aufweisen, die zudem aufeinander justiert sind. Wird in diesem Fall die Folie auf den Chuck abgesenkt, dann gelangen sämtliche Nadeln mittels Federkraft durch die Löcher hindurch und damit in elektrischen Kontakt mit der Waferrückseite, ohne die Rückseite aber zu beschädigen. Auf diese Weise ist ein definierter elektrischer Rückseitenkontakt gewährleistet, so dass jedem Halbleiterbauelement dieselben Messbedingungen zuteil werden.

Das Raster der Löcher muss jedoch nicht notwendigerweise dem Raster der Ausnehmungen entsprechen bzw. die beiden Raster müssen nicht notwendigerweise aufeinander justiert sein. Über die jeweiligen Federn der Nadeln wird gewährleistet, dass jede Nadel auch in Kontakt entweder mit der Folie oder mit der Waferrückseite gelangt. Auf diese Weise wird mithin gewährleistet, dass der Wafer weitestgehend gleichmäßig auf den Nadeln aufliegt. Für die weitere Handhabung des Wafers ist dies schon ausreichend. Zum Testen der Bauelemente des Wafers sind jedoch höhere Anforderungen an die Auflageart zu stellen. Zur Kontaktierung der Waferrückseite reichte es theoretisch schon aus, wenn mindestens eine Nadel elektrisch die Waferrückseite kontaktiert, jedoch wäre in diesem Fall zwar ein gleichmäßige Auflagefläche geschaffen, allerdings wären beim Testen der Bauelemente diese ungleichen Messbedingungen unterworfen. Zum ordnungsgemäßen Testen ist es daher erforderlich, dass eine Vielzahl etwa gleich verteilter Nadeln die Waferrückseite kontaktiert.

In einer Ausgestaltung ist auf eine Oberfläche der Folie eine Klebeschicht aufgebracht. Die Klebeschicht dient dem Halten des Wafers während dessen Handhabung bzw. während dem Testen. Alternativ kann auch auf eine Klebeschicht verzichtet werden, wenn als Folie ein Material mit hohem adhäsiven Kräften an einer ihrer Oberfläche vorgesehen ist. In einer Weiterbildung für die Folie und/oder die Klebeschicht ein elektrisch leitfähiges Material verwendet werden. In diesem Falle kann auf die Löcher in der Folie verzichtet werden, da ein elektrischer Kontakt der Folie zur Waferrückseite bereits über das Folienmaterial erzeugt wird.

Die Haftkraft der Folie bzw. die Klebekraft der Klebeschicht bestimmt im wesentlichen das Verhältnis von Lochquerschnitt für die Kontaktierung zu adhäsiven bzw. klebenden Oberflächenbereichen. Dabei ergibt sich jedoch das Problem, dass die erforderliche Haft- bzw. Klebekraft so groß gewählt werden muss, dass ein späteres, automatisiertes Ablösen der Halbleiterbauelemente von der Folie signifikant erschwert bzw. nahezu unmöglich wird. Dieses Problem kann durch geeignete Folien-Materialien bzw. Klebematerialien gelöst werden. Beispielsweise kann die Folie ein Mittel zur Klebekraftabsenkung bzw. zur Senkung der adhäsiven Kraft aufweisen. Hierzu kann als Klebeschicht ein Material vorgesehen sein, welches unter Einwirkung von UV-Bestrahlung und/oder thermischer Belastung eine geringere Klebekraft bzw. eine geringere adhäsive Kraft aufweist. Wenn die Haft- bzw. Klebekraft nicht mehr erwünscht ist, können somit mittels der genannten Materialien in Verbindung mit UV-Licht bzw. Wärme die Halbleiterbauelemente dennoch leicht von der Folie abgelöst werden.

In einer vorteilhaften Ausgestaltung wird die Folie mit dem darauf befestigten Wafer mittels eines Vakuums auf dem Chuck fixiert. Zu diesem Zweck weist die erfindungsgemäße Anordnung eine Vakuumeinrichtung auf, über die im Chuck vorgesehene, weitere Ausnehmungen mit einem von der Vakuumeinrichtung bereitgestellten Vakuum beaufschlagbar ist. Dies ist insbesondere dann besonders vorteilhaft, wenn die einzelnen Halbleiterbauelemente des Wafers bereits gesägt sind. Diese Halbleiterbauelemente werden dann lediglich durch die Folie zusammengehalten. Ohne Bereitstellung eines Vakuums würden in diesem Falle die in der Mitte des Wafers befindlichen Halbleiterbauelemente nicht mehr definiert kontaktiert werden.

Das Zersägen der Wafer zur Trennung der Halbleiterbauelemente voneinander kann vorteilhafterweise auch vor dem Testen dieser Halbleiterbauelemente erfolgen. Dies ist besonders vorteilhaft, da dadurch die Einzelbeurteilung der einzelnen Halbleiterbauelemente unabhängig von Wafereffekten, die beispielsweise von benachbarten Halbleiterbauelementen ausgehen, möglich wird.

Die erfindungsgemäße Anordnung bzw. das erfindungsgemäße Verfahren ist zum Handhaben und Testen eines dünnen Wafers vorgesehen. Unter einem dünnen Wafer ist ein Wafer mit einer Dicke kleiner 200 µm, vorteilhafterweise von kleiner 120 µm, zu verstehen. Beispielsweise weist ein dünner Wafer mit einem Waferdurchmesser D = 150mm eine typische Dicke von d = 100µm auf. Allgemein könnte also ein dünner Wafer durch das Verhältnis von Waferdurchmesser D zu Waferdicke d definiert werden, beispielsweise durch D/d > 1000.

Die erfindungsgemäße Anordnung bzw. das erfindungsgemäße Verfahren eignet sich also insbesondere für sogenannte unstabilisierte Wafer. Unter unstabilisierten Wafern sind solche Wafer zu verstehen, bei denen aufgrund des Verhältnisses von Waferdicke zu Waferdurchmesser eine Planarität der Oberfläche nicht mehr gewährleisten ist. Unstabilisierten Wafern ist typischerweise das Problem einer gewellten, verbogenen oder gedrehten Oberfläche inhärent. Der besondere Vorteil der vorliegenden Erfindung besteht darin, dass auch solche Wafer definiert elektrisch kontaktiert werden können, was mittels herkömmlicher Verfahren und Anordnungen nicht mehr möglich ist.

Die erfindungsgemäße Anordnung eignet sich also besonders vorteilhaft zum Testen dünner Wafer, da hier die Herstellung eines definierten, elektrischen Rückseitenkontaktes zur Bereitstellung definierter Messbedingungen für alle Halbleiterbauelemente besonders wichtig ist. Gleichwohl bleibt festzuhalten, dass die erfindungsgemäße Anordnung selbstverständlich auch zum Handhaben dünner Wafer vorteilhaft eingesetzt werden kann. Unter Handhaben ist jeder Prozessschritt zu verstehen, bei dem der dünne Wafer auf einem Chuck aufgesetzt wird und anschließend bearbeitet bzw. prozessiert wird. Ein solcher Handhabungsprozess kann beispielsweise bei der Fotolithografie, beim nass- oder trockenchemischen Ätzen, beim Beschriften, beim Reinigen und dergleichen vorgesehen sein. Selbstverständlich ist die erfindungsgemäße Anordnung nicht ausschließlich zum Handhaben und Testen dünner Wafer geeignet, sondern auch zum Handhaben und Testen von herkömmlichen, dicken Wafern (größer 200 µm) einsetzbar.

In einer typischen Ausgestaltung ist die Folie zur Stabilisierung in einen umlaufenden Stabilisierungsring eingespannt, so dass der Wafer plan auf der Folie aufliegt. Der dünne, häufig sogar biegsame Wafer wird so durch die Folie und den Stabilisierungsring stabilisiert und fixiert. Eine solche Anordnung bestehend aus Stabilisierungsring und Folie wird auch als Sägeframe bezeichnet.

Vorteilhafterweise ist zu diesem Zwecke eine Justiervorrichtung vorgesehen, welche das Raster der in der Folie vorgesehenen Löcher auf das Raster der Nadeln justiert. Dadurch kann gewährleistet werden, dass sämtliche Nadeln über die Löcher der Folie auch die Waferrückseite kontaktieren. Darüber hinaus lässt sich so auch der Handhabungs- und Testprozess weitestgehend automatisieren.

Die Vorderseite des Wafers bzw. der Halbleiterbauelemente werden hierbei in bekannter Art und Weise über einzelne Nadeln oder über eine Nadelkarte kontaktiert. Alternativ oder zusätzlich könnte auch die Rückseite mittels einer Nadelkarte kontaktiert werden. Unter einer Nadelkarte ist eine Anordnung (Array) einer Vielzahl von Nadeln zu verstehen, die zum Kontaktieren einzelner Halbleiterbauelemente bzw. einzelner Teile des Wafers dienen und die zum Ausgleich des Kontaktdruckes gefedert sind. Im Unterschied zu einem mit Nadeln versehenen Chuck, bei dem eine ganzflächige Nadelkontaktierung zum Wafer erfolgt, können bei einer Nadelkarte einzelne Chips gezielt kontaktiert werden, wobei zum Kontaktieren der einzelnen Chips die Nadelkarte über den Wafer "versteppt" werden bzw. bewegt werden muss.

Die Erfindung wird nachfolgend anhand der in den Figuren der Zeichnung angegebenen Ausführungsbeispiele näher erläutert. Es zeigt dabei:
- Figur 1: eine Querschnittsdarstellung der erfindungsgemäßen Anordnung zum Handhaben und/oder Testen eines dünnen Wafers;
- Figur 2: eine schematische Darstellung einer in einer Bohrung des Chucks angeordneten, gefederten Nadel zur Kontaktierung einer Waferoberfläche;
- Figur 3: in einer schematischen Darstellung einen Ausschnitt der Oberfläche des Chucks, auf der eine mit einer Vielzahl von Halbleiterchips versehene Folie ausgelegt ist;
- Figur 4: eine erste Detaildarstellung eines auf einer Folie aufgebrachten Wafers;
- Figur 5: eine zweite Detaildarstellung eines auf einer Folie aufgebrachten Wafers;
- Figur 6: eine dritte Detaildarstellung eines auf einer Folie aufgebrachten Wafers.

In den nachfolgenden Figuren sind - sofern nichts anderes angegeben ist - gleiche oder funktionsgleiche Elemente und Teile mit gleichen Bezugszeichen versehen worden.

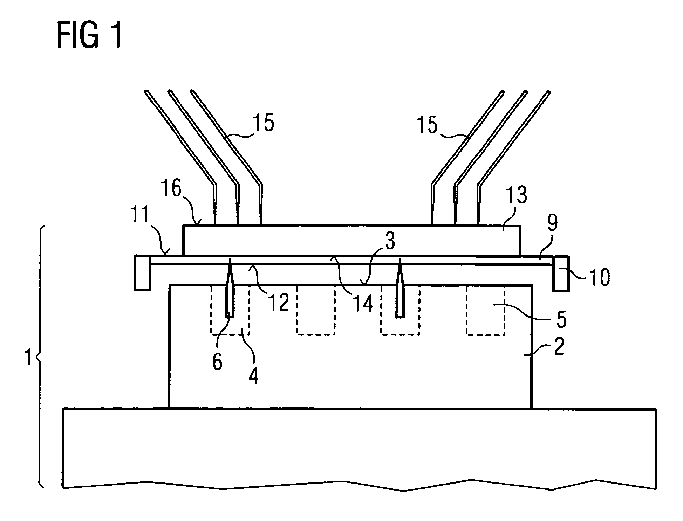

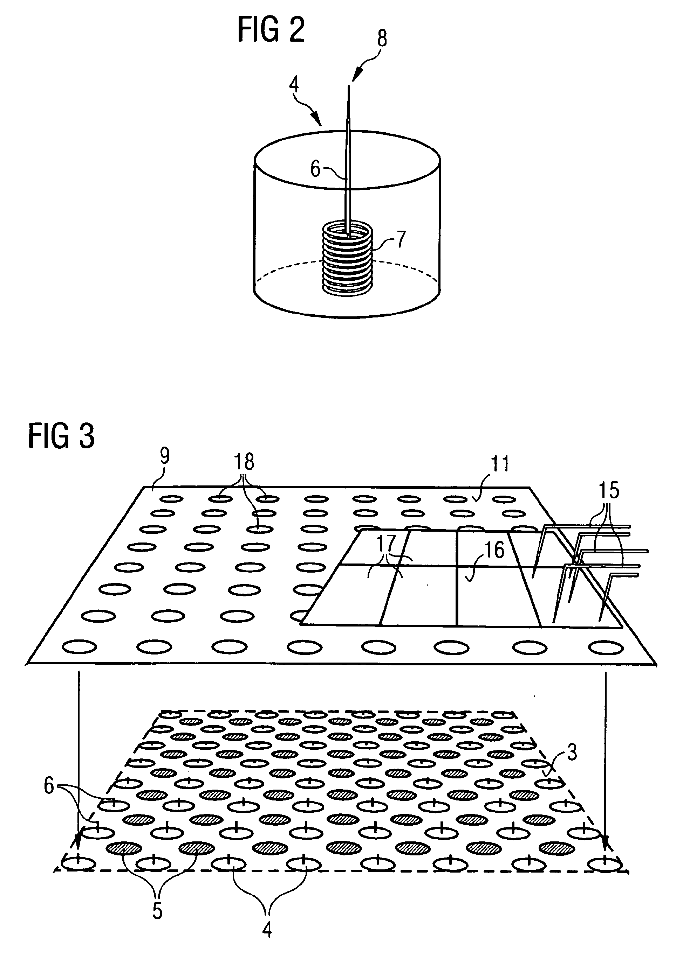

In Figur 1 ist mit Bezugszeichen 1 die erfindungsgemäße Anordnung zur Aufnahme, zum Bearbeiten und/oder zum Testen eines dünnen Wafers bezeichnet. Die Anordnung 1 weist einen typischerweise zylinderförmigen Chuck 2 auf. Der Chuck 2 weist erfindungsgemäß eine Vielzahl von zur Oberfläche 3 hin offene Bohrungen 4, 5 auf. Wie aus Figur 2 hervorgeht, ist in den Bohrungen 4 jeweils eine Nadel 6 angeordnet, deren Nadelspitze 8 aus der Bohrung 4 und somit über die Oberfläche 3 aus dem Chuck 2 herausragt. Die Nadel 6 ist mit einer Feder 7 gekoppelt, so dass sie durch Federkraft innerhalb ihrer Bohrung 4 vertikal bewegbar ist. Der Chuck 2 weist ferner zweite Bohrungen 5 auf, die mit einer in Figur 1 nicht dargestellte Vakuumvorrichtung, beispielsweise einer Vakuumpumpe, in Verbindung stehen, so dass ein Unterdruck in den zweiten Bohrungen 5 erzeugbar ist.

Die Anordnung 1 weist ferner eine Folie 9 auf. Die Folie 9 ist typischerweise in einen Spannring 10 eingespannt, um dadurch möglichst planare Folienoberflächen 11, 12 zu gewährleisten. Auf die erste Oberfläche 11 (Oberseite) der Folie 9 ist der zu handhabende bzw. zu testende Wafer 13 befestigt. Der Wafer besteht aus einem Halbleitermaterial, beispielsweise aus Silizium. Der Wafer 13 liegt dabei mit seiner Waferrückseite 14, auf die typischerweise eine großflächige Metallisierung aufgebracht ist, auf der ersten Oberfläche 11 der Folie 9 auf. Die in den Spannring 10 eingespannte Folie 9 mit dem darauf befestigten Wafer 13 liegt mit ihrer zweiten Oberfläche 12 (Unterseite) auf den aus dem Chuck 2 herausragenden Nadeln 6 bzw. deren Spitzen 8 auf. Durch die vertikale Beweglichkeit der Nadeln 6 entsteht so ein definierter Kontakt zwischen Nadeln 6 und Folie 9 bzw. Waferrückseite 14. Dieser Kontaktierungsmechanismus wird nachfolgend noch anhand der Figuren 3 bis 6 ausführlich erläutert. Über Kontaktnadeln 15, die die Wafervorderseite 16 kontaktieren, lassen sich anschließend die einzelnen Halbleiterbauelemente des Wafers 13 kontaktieren und testen.

Der Chuck 2 weist typischerweise eine in Figur 1 nicht dargestellte Heizvorrichtung auf, über die der Chuck 2 und somit auch die mit dem Chuck 2 in Verbindung stehende Folie 9 und der darauf befestigte Wafer 13 aufgeheizt werden können.

Figur 3 zeigt in einer stark schematisierten perspektivischen Darstellung einen Ausschnitt der Oberfläche des Chucks 2, auf der eine mit einer Vielzahl von Halbleiterchips versehene Folie 9 ausgelegt ist. Die Oberfläche 3 des Chucks 2 weist eine Vielzahl von Bohrungen 4, 5 auf, wobei aus den ersten Bohrungen 4 eine Vielzahl von Nadeln (Nadel-Array) 6 herausragen und die zweiten Bohrungen 5 (grau hinterlegt) der Vakuumbeaufschlagung der auf die Oberfläche 3 aufliegenden Folie 9 dient. Der Wafer 13 ist auf der Folie 9 befestigt, wobei der besseren Übersicht halber lediglich einige wenige Halbleiterbauelemente 17 des Wafers 13 dargestellt sind. Die Folie 9 weist eine Vielzahl durchgehender Löcher 18 auf. Die ersten Bohrungen 4 sowie die Löcher 18 sind hier jeweils in einem Raster angeordnet. Im Beispiel in Figur 3 sind dabei das Raster der Löcher 18 auf das Raster der ersten Bohrungen justiert.

Über die Kontaktnadeln 15 lässt sich dann die Wafervorderseite 16 bzw. die entsprechenden Kontaktstellen der Halbleiterbauelemente 17 kontaktieren und testen.

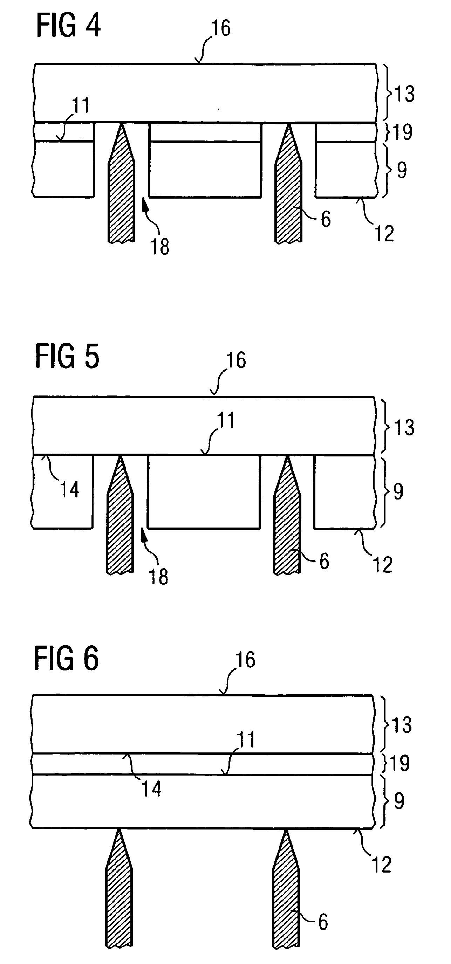

Anhand der schematischen Querschnitte der Figuren 4 bis 6 werden verschiedene Arten der Verbindung von Folie 9 und Wafer 13 dargelegt.

In Figur 4 weist die Folie 9 an ihrer Oberseite 11 eine Klebeschicht 19 auf. Die Klebeschicht 19 kann entweder Bestandteil der Folie 9 sein oder eigens auf die Folie, beispielsweise durch Aufschleudern, aufgebracht werden. Der Wafer 13 wird hier also mittels Klebekräften der Klebeschicht 19 auf der Folie 9 gehalten.

In Figur 5 wird auf eine Klebeschicht 19 verzichtet. Die Folie 9 besteht hier aus einem solchen Material bzw. die Oberflächen 11, 14 von Folie 9 und Wafer 13 sind derart ausgebildet, dass der Wafer 13 mittels Adhäsionskräften auf der Folie 9 haftet.

Im Falle der Figuren 4 und 5 können die Folie 9 bzw. deren Klebeschicht 19 beispielsweise aus einem isolierenden Material bestehen. Um einen elektrischen Kontakt zur Waferrückseite 14 zu erzeugen, sind durch die Folie 9 bzw. deren Klebeschicht 19 durchgehende Löcher 18 vorgesehen, über die die Nadeln 6 die Waferrückseite 16 kontaktieren.

Im Ausführungsbeispiel in Figur 6 weist die Folie 9 keine Löcher 18 auf. Die Folie 9 sowie deren Klebeschicht 19 bestehen in diesem Beispiel aus einem elektrisch leitfähigen Material. Die Waferrückseite 16 lässt sich hier elektrisch kontaktieren, indem lediglich die Unterseite 12 der Folie 9 von den Nadeln 6 kontaktiert werden.

Zusammenfassend kann festgestellt werden, dass durch die Verwendung einer Vielzahl gefederter Nadeln auf sehr einfache, jedoch nichts desto trotz sehr effektive Weise eine definierte Kontaktierung bzw. Auflage der Rückseite dünner Wafer zum Zwecke des Testens bzw. Handhabens realisiert werden kann, ohne dass die Nachteile (Waferbruch, geringe Ausbeute) von Anordnungen bzw. Verfahren nach dem Stand der Technik in Kauf genommen werden müssten.

Die Erfindung sei nicht ausschließlich auf die Ausführungsbeispiele der Figuren 1 bis 6 beschränkt. Vielmehr lässt sich die Erfindung im Rahmen des fachmännischen Handelns und Wissens in geeigneter Weise in mannigfaltigen Ausführungsformen und Abwandlungen realisieren.

### Bezugszeichenliste

- 1: Anordnung zum Handhabend und Testen eines dünnen Wafers
- 2: Chuck
- 3: Oberfläche des Chucks
- 4: erste Ausnehmungen/Bohrungen
- 5: zweite Ausnehmungen/Bohrungen
- 6: (gefederte) Nadeln
- 7: Feder
- 8: Nadelspitze
- 9: Folie
- 10: Spannring, Stabilisierungsring
- 11: Oberseite der Folie
- 12: Unterseite der Folie
- 13: Wafer
- 14: ersten Oberfläche des Wafers, Waferrückseite
- 15: Kontaktnadeln
- 16: zweite Oberfläche des Wafers, Wafervorderseite
- 17: Halbleiterbauelemente
- 18: Löchern der Folie
- 19: Klebeschicht

## Patentansprüche

1. Anordnung zur Aufnahme, zum Bearbeiten und/oder Testen eines Wafers,
- mit einem Chuck (2), der im Bereich seiner Oberfläche (3) eine Vielzahl vertikal beweglicher, gepufferter Nadeln (6) aufweist,
- mit einer Folie (9), die zum Bearbeiten und/oder Testen des Wafers (13) in einer Ebene parallel zu jener Ebene, in der sich die Spitzen der Nadeln (6) befinden, positioniert ist,
**dadurch gekennzeichnet, dass**
die Folie (9) dazu ausgebildet ist, eine erste Oberfläche eines Wafers mit adhäsiven Kräften der Folie (9) oder mit Hilfe einer Klebeschicht (19) auf der Folie (9) zu halten.

2. Anordnung nach Anspruch 1,
**dadurch gekennzeichnet,**
**dass** der Chuck (2) an seiner Oberfläche (3) erste Ausnehmungen (4) aufweist, wobei in jeweils einer Ausnehmung (4) eine gefederte Nadel (6) vorgesehen ist, die jeweils mit ihrer Nadelspitze (8) aus der Oberfläche (3) des Chucks (2) herausragt.

3. Anordnung nach einem der vorstehenden Ansprüche,
**dadurch gekennzeichnet,**
**dass** die Folie (9) mehrere Löcher (18) aufweist, durch die mindestens eine Nadel (6) die erste Oberfläche (14) des Wafers (13) kontaktiert.

4. Anordnung nach Anspruch 3,
**dadurch gekennzeichnet,**
**dass** die ersten Ausnehmungen (4) und die Löcher (18) ein gleiches Raster aufweisen und aufeinander justiert sind.

5. Anordnung nach einem der vorstehenden Ansprüche,
**dadurch gekennzeichnet,**
**dass** zwischen Folie (9) und Wafer (13) eine Klebeschicht (19) vorgesehen ist.

6. Anordnung nach Anspruch 5,
**dadurch gekennzeichnet,**
**dass** als Klebeschicht (19) ein Material vorgesehen ist, welches unter Einwirkung von UV-Bestrahlung und/oder thermischer Belastung eine geringere Klebekraft aufweist.

7. Anordnung nach einem der Ansprüche 1 bis 4,
**dadurch gekennzeichnet,**
**dass** als Folie (9) ein Material vorgesehen ist, welches an einer Oberfläche (11), auf der der Wafer (13) aufliegt, hohe Adhäsionskräfte aufweist.

8. Anordnung nach Anspruch 7,
**dadurch gekennzeichnet,**
**dass** die Folie (9) ein Material aufweist, welches unter Einwirkung von UV-Bestrahlung und/oder thermischer Belastung eine geringere adhäsive Kraft aufweist.

9. Anordnung nach einem der vorstehenden Ansprüche,
**dadurch gekennzeichnet,**
**dass** das Material der Folie (9) und/oder der Klebeschicht (19) elektrisch leitfähig ist.

10. Anordnung nach einem der vorstehenden Ansprüche,
**dadurch gekennzeichnet,**
**dass** eine Vakuumeinrichtung vorgesehen ist und der Chuck (2) zweite Ausnehmungen (5) aufweist, über welche die auf den Nadeln (6) des Chucks (2) aufliegende Folie (9) mit einem von der Vakuumeinrichtung bereitgestellten Vakuum beaufschlagbar ist.

11. Anordnung nach einem der vorstehenden Ansprüche,
**dadurch gekennzeichnet,**
**dass** der Wafer (13) aus einer Vielzahl, bereits in einzelne Halbleiterbauelemente (17) zersägter Teile besteht.

12. Anordnung nach einem der vorstehenden Ansprüche,
**dadurch gekennzeichnet,**
**dass** der Wafer (13) als dünner Wafer ausgebildet ist, der eine Dicke von kleiner 200 µm, insbesondere von kleiner 120 µm, aufweist.

13. Anordnung nach einem der vorstehenden Ansprüche,
**dadurch gekennzeichnet,**
**dass** die Folie (9) zur Stabilisierung in einen Stabilisierungsring (10) eingespannt ist.

14. Anordnung nach einem der Ansprüche 3 bis 13,
**dadurch gekennzeichnet,**
**dass** eine Justiervorrichtung vorgesehen ist, welche das Raster der Löcher (18) auf das Raster der Nadeln (6) justiert.

15. Anordnung nach einem der vorstehenden Ansprüche,
**dadurch gekennzeichnet,**
**dass** eine Nadelkarte vorgesehen ist, die zum Kontaktieren von Kontaktstellen einzelner Halbleiterbauelemente (17) an einer zweiten Oberfläche (16) des Wafers (13) eine Vielzahl von Kontaktnadeln (15) aufweist.

16. Verfahren zum Bearbeiten und/oder Testen eines Wafers (13) mittels einer Anordnung (1) nach einem der vorstehenden Ansprüche,
**gekennzeichnet durch** die folgenden Verfahrensschritte:
(A) Ein Chuck (2) mit einer Vielzahl von aus Bohrungen (4) herausragenden, gefederten Nadeln (6) wird bereitgestellt;
(B) Ein Wafer (13) wird auf eine Oberseite (11) einer Folie (9) befestigt;
(C) Die Folie (9) mit dem befestigten Wafer (13) wird mit ihrer Unterseite (12) auf die gefederten Nadeln (6) abgelegt;
(D) Der Wafer (13) wird anschließend gehandhabt und/oder getestet,
**dadurch gekennzeichnet, dass**
der Wafer (13) mit adhäsiven Kräften der Folie (9) oder mit Hilfe einer Klebeschicht (19) auf der Folie (9) befestigt wird.

17. Verfahren nach Anspruch 16,
**dadurch gekennzeichnet,**
**dass** die Folie (9) mit dem darauf befestigten Wafer (13) wird mittels Vakuum auf dem Chuck (2) fixiert wird.

18. Verfahren nach einem der Ansprüche 16 bis 17,
**dadurch gekennzeichnet,**
**dass** das Raster der Löcher (18) auf das Raster der Nadeln (6) justiert wird.

19. Verfahren nach einem der Ansprüche 16 bis 18,
**dadurch gekennzeichnet,**
**dass** der Wafer (13) vor dem Testen in einzelne Halbleiterbauelemente (17) gesägt wird.

20. Verfahren nach einem der Ansprüche 16 bis 19,
**dadurch gekennzeichnet,**
**dass** vor dem Ablösen des Wafers (13) bzw. der Halbleiterbauelemente (17) von der Folie (9) diese mit UV-Bestrahlung beaufschlagt oder erwärmt werden.

21. Verfahren nach einem der Ansprüche 16 bis 20,
**dadurch gekennzeichnet,**
**dass** die zweite Oberfläche (16) des Wafers (13) bzw. die Halbleiterbauelemente (17) über eine Nadelkarte kontaktiert werden.

## Claims

1. Arrangement for receiving, processing and/or testing a wafer,
- having a chuck (2) which has a multiplicity of vertically movable buffered needles (6) in the region of its surface (3), and
- having a film (9) which is positioned on a plane parallel to that plane on which the tips of the needles (6) are situated for the purpose of processing and/or testing the wafer (13),
**characterized in that**
the film (9) is designed to hold a first surface of a wafer using adhesive forces of the film (9) or with the aid of an adhesive layer (19) on the film (9).

2. Arrangement according to Claim 1,
**characterized in that**
the chuck (2) has first recesses (4) on its surface (3), a sprung needle (6) whose needle tip (8) projects from the surface (3) of the chuck (2) being provided in a respective recess (4).

3. Arrangement according to one of the preceding claims,
**characterized in that**
the film (9) has a plurality of holes (18) through which at least one needle (6) makes contact with the first surface (14) of the wafer (13).

4. Arrangement according to Claim 3,
**characterized in that**
the first recesses (4) and the holes (18) have the same grid pattern and are aligned with respect to one another.

5. Arrangement according to one of the preceding claims,
**characterized in that**
an adhesive layer (19) is provided between the film (9) and the wafer (13).

6. Arrangement according to Claim 5,
**characterized in that**
a material which has a lower adhesive force under the action of UV irradiation and/or thermal loading is provided as the adhesive layer (19).

7. Arrangement according to one of Claims 1 to 4,
**characterized in that**
a material which has high adhesion forces on a surface (11) on which the wafer (13) rests is provided as the film (9).

8. Arrangement according to Claim 7,
**characterized in that**
the film (9) has a material which has a lower adhesive force under the action of UV irradiation and/or thermal loading.

9. Arrangement according to one of the preceding claims,
**characterized in that**
the material of the film (9) and/or of the adhesive layer (19) is electrically conductive.

10. Arrangement according to one of the preceding claims,
**characterized in that**
a vacuum device is provided and the chuck (2) has second recesses (5) which can be used to apply a vacuum, which is provided by the vacuum device, to the film (9) resting on the needles (6) of the chuck (2).

11. Arrangement according to one of the preceding claims,
**characterized in that**
the wafer (13) comprises a multiplicity of parts which have already been sawn into individual semiconductor components (17).

12. Arrangement according to one of the preceding claims,
**characterized in that**
the wafer (13) is in the form of a thin wafer having a thickness of less than 200 µm, in particular of less than 120 µm.

13. Arrangement according to one of the preceding claims,
**characterized in that**
the film (9) is clamped into a stabilization ring (10) for stabilizing purposes.

14. Arrangement according to one of Claims 3 to 13,
**characterized in that**
an aligning apparatus which aligns the grid pattern of the holes (18) with the grid pattern of the needles (6) is provided.

15. Arrangement according to one of the preceding claims,
**characterized in that**
a needle card which has a multiplicity of contact needles (15) for the purpose of making contact with contact locations of individual semiconductor components (17) on a second surface (16) of the wafer (13) is provided.

16. Method for processing and/or testing a wafer (13) using an arrangement (1) according to one of the preceding claims,
**characterized by** the following method steps:
(A) a chuck (2) having a multiplicity of sprung needles (6) which project from bores (4) is provided;
(B) a wafer (13) is fastened to a top side (11) of a film (9) ;
(C) the underside (12) of the film (9) with the fastened wafer (13) is placed onto the sprung needles (6);
(D) the wafer (13) is then handled and/or tested,
**characterized in that**
the wafer (13) is fastened to the film (9) using adhesive forces of the film (9) or with the aid of an adhesive layer (19).

17. Method according to Claim 16,
**characterized in that**
the film (9) with the wafer (13) fastened to it is fixed on the chuck (2) by means of a vacuum.

18. Method according to either of Claims 16 and 17,
**characterized in that**
the grid pattern of the holes (18) is aligned with the grid pattern of the needles (6).

19. Method according to one of Claims 16 to 18,
**characterized in that**
the wafer (13) is sawn into individual semiconductor components (17) before testing.

20. Method according to one of Claims 16 to 19,
**characterized in that**,
before the wafer (13) or the semiconductor components (17) is/are removed from the film (9), UV irradiation is applied to it/them or it/they is/are heated.

21. Method according to one of Claims 16 to 20,
**characterized in that**
contact is made with the second surface (16) of the wafer (13) or the semiconductor components (17) using a needle card.

## Revendications

1. Dispositif pour recevoir, traiter et/ou tester une plaquette, comprenant :
- un mandrin (2) dont la surface supérieure (3) comporte un grand nombre d'aiguilles (6), amorties, mobiles verticalement,
- un film (9) placé dans un plan parallèle au plan des pointes des aiguilles (6) pour traiter et/ou tester la plaquette (13),
**caractérisé en ce que**
le film (9) est réalisé pour tenir une première surface d'une plaquette avec des forces adhésives du film (9) ou à l'aide d'une couche de colle (19) sur le film (9).

2. Dispositif selon la revendication 1,
**caractérisé en ce que**
la surface supérieure (3) du mandrin (2) comporte des cavités (4) et dans chaque cavité (4) une aiguille à ressort (6) dépasse chaque fois par sa pointe (8) de la surface supérieure (3) du mandrin (2).

3. Dispositif selon l'une des revendications précédentes,
**caractérisé en ce que**
le film (9) comporte plusieurs orifices (18) à travers lesquels au moins une aiguille (6) est en contact avec la première surface supérieure (14) de la plaquette (13).

4. Dispositif selon la revendication 3,
**caractérisé en ce que**
les premières cavités (4) et les orifices (18) correspondent à une même trame et sont ajustés les uns aux autres.

5. Dispositif selon l'une des revendications précédentes,
**caractérisé par**
une couche de colle (19) entre le film (9) et la plaquette (13).

6. Dispositif selon la revendication 5,
**caractérisé en ce que**
la couche de colle (19) est une matière qui sous l'action du rayonnement ultraviolet et/ou d'une sollicitation thermique présente une force adhésive réduite.

7. Dispositif selon l'une des revendications 1 à 4,
**caractérisé en ce que**
le film (9) est une matière dont la surface supérieure (11) sur laquelle s'appuie la plaquette (13) présente des forces adhésives élevées.

8. Dispositif selon la revendication 7,
**caractérisé en ce que**
le film (9) présente une matière qui, sous l'action du rayonnement ultraviolet et/ou d'une contrainte thermique, a une force adhésive moindre.

9. Dispositif selon l'une des revendications précédentes,
**caractérisé en ce que**
la matière du film (9) et/ou de la couche adhésive (19) est électroconductrice.

10. Dispositif selon l'une des revendications précédentes,
**caractérisé par**
une installation de vide et le mandrin (2) comporte des secondes cavités (5) par lesquelles on peut appliquer le vide fourni par l'installation de vide au film (9) appliqué sur les aiguilles (6) du mandrin (2).

11. Dispositif selon l'une des revendications précédentes,
**caractérisé en ce que**
la plaquette (13) se compose d'un grand nombre de parties déjà sciées en composants semi-conducteurs (17) séparés.

12. Dispositif selon l'une des revendications précédentes,
**caractérisé en ce que**
la plaquette (13) est une plaquette mince ayant une épaisseur inférieure à 200 µm, notamment inférieure à 120 µm.

13. Dispositif selon l'une des revendications précédentes,
**caractérisé en ce que**
le film (9) est fixé dans un anneau de stabilisation (10).

14. Dispositif selon l'une des revendications 3 à 13,
**caractérisé par**
un dispositif d'ajustage qui ajuste la trame des orifices (18) selon la trame des aiguilles (6).

15. Dispositif selon l'une des revendications précédentes,
**caractérisé par**
une carte d'aiguilles ayant sur une seconde surface supérieure (16) de la plaquette (13) un grand nombre d'aiguilles de contact (15) pour réaliser le contact avec les points de contact des différents composants semi-conducteurs (17).

16. Procédé de traitement et/ou de test d'une plaquette (13) à l'aide d'un dispositif (1) selon l'une des revendications précédentes,
**caractérisé par** les étapes suivantes :
(A) on fournit un mandrin (2) ayant un grand nombre d'aiguilles (6) à ressort dépassant des perçages (4),
(B) on fixe une plaquette (13) à la surface supérieure (11) d'un film (9),
(C) on dépose le film (9) avec la plaquette (13) fixée à celui-ci, par sa face inférieure (12) sur les aiguilles à ressort (6),
(D) on manipule ensuite ou on teste la plaquette (13),
**caractérisé en ce qu'**
on fixe la plaquette (13) avec des forces adhésives du film (9) ou à l'aide d'une couche adhésive (19) sur le film (9).

17. Procédé selon la revendication 16,
**caractérisé en ce qu'**
on fixe le film (9) portant solidairement la plaquette (13) par l'action du vide sur le mandrin (12).

18. Procédé selon l'une des revendications 16 à 17,
**caractérisé en ce qu'**
on ajuste la trame des orifices (18) sur la trame des aiguilles (6).

19. Procédé selon l'une des revendications 16 à 18,
**caractérisé en ce qu'**
on scie la plaquette (13) en éléments semi-conducteurs distincts (17) avant d'effectuer les tests.

20. Procédé selon l'une des revendications 16 à 19,
**caractérisé en ce qu'**
on applique un rayonnement ultraviolet ou on chauffe la plaquette ou les composants semi-conducteurs (17) avant de séparer la plaquette (13) ou les composants semi-conducteurs (17) par rapport au film (9).

21. Procédé selon l'une des revendications 16 à 20,
**caractérisé en ce qu'**
on réalise le contact de la seconde surface supérieure (16) de la plaquette (13) ou des composants semi-conducteurs (17) par l'intermédiaire d'une carte à aiguilles.
